# EUROPEAN PATENT APPLICATION

(11) **EP 1 104 021 A1**
(43) Date of publication of application: **30.05.2001**
(21) Application number: 99830741.7
(22) Date of filing: 29.11.1999
(51) Int. Cl.: H01L 21/8239, H01L 21/8247

(54) **Process for the fabrication of integrated circuits with low voltage MOS transistors, EPROM cells and high voltage MOS transistors**

(71) Applicant: STMicroelectronics S.r.l., 20041 Agrate Brianza (Milano) (IT)
(72) Inventor: Palumbo, Elisabetta, 20155 Milano (IT); Peschiaroli, Daniela, 20131 Milano (IT); Zatelli, Nicola, 24100 Bergamo (IT)
(74) Representative: Maggioni, Claudio

(57) **Abstract**

The active areas and the body regions for the LV MOS transistors, for the HV MOS transistors and for the EPROM cells are formed on a silicon substrate, a layer of thermal oxide (12) is formed and a layer of polycrystalline silicon (13) is formed on it, the last-mentioned layer is removed selectively to form the floating gate electrodes (13a) of the cells, the source and drain regions (14) of the cells are formed, a composite ONO layer (15) is formed, the silicon of the areas of the LV MOS transistors is exposed, a layer of thermal oxide (16) is formed on the exposed areas, a second layer of polycrystalline silicon (17) is deposited and is then removed selectively to form the gate electrodes of the LV and HV MOS transistors (17c, 17b) and the control gate electrodes (17a) of the cells, and the source and drain regions of the LV and HV MOS transistors are formed.

Owing to the simultaneous formation of part of the gate dielectric of the HV MOS transistors and the intermediate dielectric of the cells, and the use of a material (ONO) which is impermeable to the oxygen atoms of the subsequent thermal oxidation, the number of the operations in the process is smaller than in the prior art process.

## Description

The present invention relates to the fabrication of integrated circuits and, more precisely, to a process for forming on a silicon substrate an integrated circuit comprising low voltage MOS transistors with corresponding gate electrodes separated from the substrate by a portion of a first layer of dielectric material, high voltage MOS transistors with corresponding gate electrodes separated from the substrate by a portion of a second dielectric material, and cells of the EPROM type with corresponding floating gate electrodes separated from the substrate by a portion of a third layer of dielectric material and with corresponding control electrodes separated from the corresponding floating gate electrodes by a portion of a fourth layer of dielectric material.

In the design of integrated circuit devices intended for the logical processing of digital signals, for example microprocessors, it is sometimes necessary to incorporate electrically programmable non-volatile memory cells, known as EPROM (Electrically Programmable Read Only Memory) cells of the one time programmable (OTP) type, with their corresponding decoding circuits, into the same integrated circuit. This requirement gives rise to considerable problems in manufacture, for the following reason. The logical processing circuits, or logic circuits for short, are advantageously made by low voltage technologies, in other words by processes for forming devices, particularly MOS transistors, capable of withstanding relative low voltages (1-3 V) (indicated below by the symbol LV (Low Voltage)). On the other hand, the decoding circuits of the memories require devices, essentially MOS transistors, capable of operating at relatively high voltages (7-10 V) (indicated below by the symbol HV (High Voltage). This means that the gate dielectrics of the HV devices must have physical characteristics and/or thicknesses which are different from those used in the LV devices, and therefore require special operations for their formation and definition. Finally, the gate dielectrics of EPROM cells have to have a thickness which is different again from that of the gate dielectrics of the LV devices and HV devices, and specific characteristics to ensure the permanence of the stored data over time.

A prior art process of this kind for forming the different types of device in a single integrated circuit consists of the combination of the three specific processes for forming the three types of device, in other words a process which requires a number of masking operations which is close to the sum of the masking operations of the three specific processes. However, a process of this kind entails high costs, owing to both the large number of the operations required, and the low yield resulting from this. This is because, as is known, the production yield decreases with an increase of the operations in the process.

For producing HV circuits together with LV circuits without making use of specific processes for HV devices, there is a known circuit arrangement in which two or more LV devices, connected in cascode configuration, are used. However, this solution can be applied advantageously only when the number of HV devices is small; otherwise, owing to the fact that each HV device is formed from at least two LV devices, the supplementary area required becomes unacceptably large. Moreover, this does not help in any way with the formation of the memory cells, so that all the specific operations for producing memory cells have to be added to the process in any case.

The principal object of the present invention is to propose a process which makes it possible for LV circuits, HV circuits and EPROM memory cells of the OTP type within a single integrated circuit by using a small number of operations in addition to those normally used for forming LV circuits, thus achieving a production yield very close to that which can be achieved with a process designed solely for forming logic circuits with transistors of the LV type.

This object is achieved by applying the process defined in a general way in the first claim.

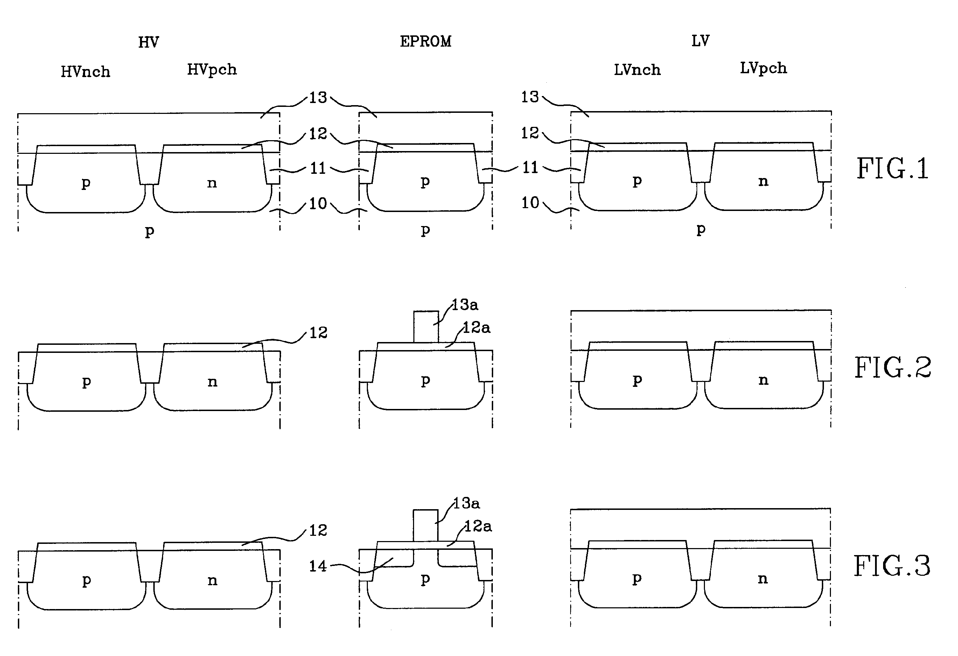

The invention will be more clearly understood from the following detailed description of an embodiment provided by way of example and therefore without restrictive intent, with reference to the attached drawings, in which Figures 1 to 8 show in cross section, schematically and not to scale, three portions of an integrated circuit formed on a wafer of monocrystalline silicon in successive steps of the process according to the invention.

The three illustrated portions relate to a pair, indicated by LV, of low voltage MOS transistors, one of the n-channel type and one of the p-channel type, indicated by LVn-ch and LVp-ch respectively; a pair, indicated by HV, of high voltage transistors, one of the n-channel type and one of the p-channel type, indicated by HVn-ch and HVp-ch respectively; and a cell, indicated by EPROM, of a matrix of EPROM cells.

Figure 1 shows the structures of the three portions after a series of well-known operations of an integrated circuit fabrication process. Briefly, these operations comprise, initially, the definition, on a substrate 10 of monocrystalline silicon, of p-type areas, known as active areas, insulated from each other by silicon dioxide inserts 11, known as the field oxide, followed by the doping of the active areas to form p- and n-type regions designed to form the body regions of the LV and HV MOS transistors and of the EPROM cells, then the formation, by thermal oxidation of the silicon of the substrate, of a relatively thin (5-10 nm) layer 12 of silicon dioxide, and finally the formation of a layer 13 of polycrystalline silicon doped with n-type impurities on the oxide layer 12.

The polycrystalline silicon is removed selectively from the areas to be used for the EPROM cells, by the use of known photolithographic techniques to form the floating gate electrodes of the EPROM cells. Only one of these electrodes, indicated by 13a, is shown in Figure 2. The portion, indicated by 12a, of the thin oxide layer 12 which is located under the gate electrode 13a constitutes the gate dielectric of the EPROM cell. At the same time, the polycrystalline silicon 13 is removed completely from the areas to be used for the HV transistors, as shown in the same Figure 2.

Doping impurities are then implanted in the p-type body regions of the cells to form n-type source and drain regions, indicated by 14 in Figure 3.

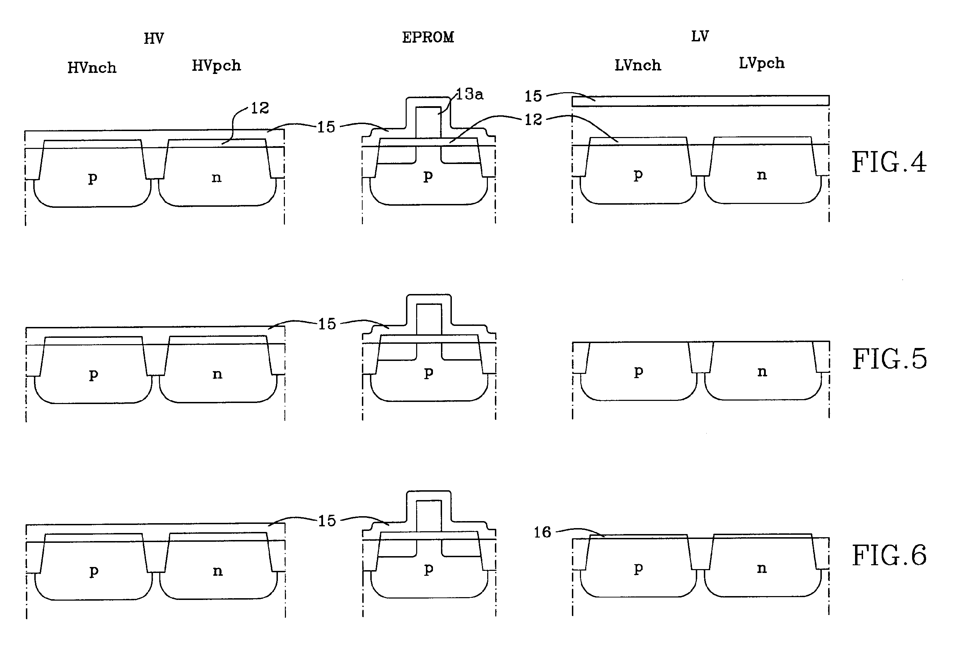

A layer 15 of composite dielectric material of the type known to those skilled in the art by the symbol ONO (Oxide-Nitride-Oxide) is then (Fig. 4) formed over the whole of the wafer. This layer is produced by depositing in succession a first layer of silicon dioxide (having a thickness in the range from 30 to 80 nm for example), a layer of silicon nitride (having a thickness in the range from 30 to 80 nm for example), and a second layer of silicon dioxide (having a thickness in the range from 30 to 80 nm for example).

The composite layer 15 is designed to form the intermediate dielectric of the EPROM cells and, together with the relatively thin thermal oxide layer 12, the gate dielectric of the HV transistors.

As is known, an ONO layer is very suitable for use as an intermediate dielectric of EPROM cells, because it provides good qualities of retention of the charges stored in the floating gate and good capacitive coupling characteristics between the floating gate and the control gate. It is also known that this material is not generally suitable for use as a gate dielectric of transistors, because the nitride layer easily absorbs doping impurities during the fabrication process. With the process according to the invention, however, this negative aspect is largely avoided by the presence of the thermal oxide layer 12 which increases the distance of the nitride layer from the surface of the substrate.

The thickness of the layers which form the composite layer 15 is selected with regard to the characteristics (especially the threshold voltage) of the HV transistors which are to be obtained.

Owing to the presence of the silicon nitride in the composite layer 15, according to the invention, it is possible to carry out a successive stage of thermal oxidation on other areas of the substrate. This is because the nitride layer prevents the oxygen atoms from reaching the surface of the substrate to combine with the silicon and form an oxide layer which would increase the thickness of the dielectric of the HV transistors in an undesirable way.

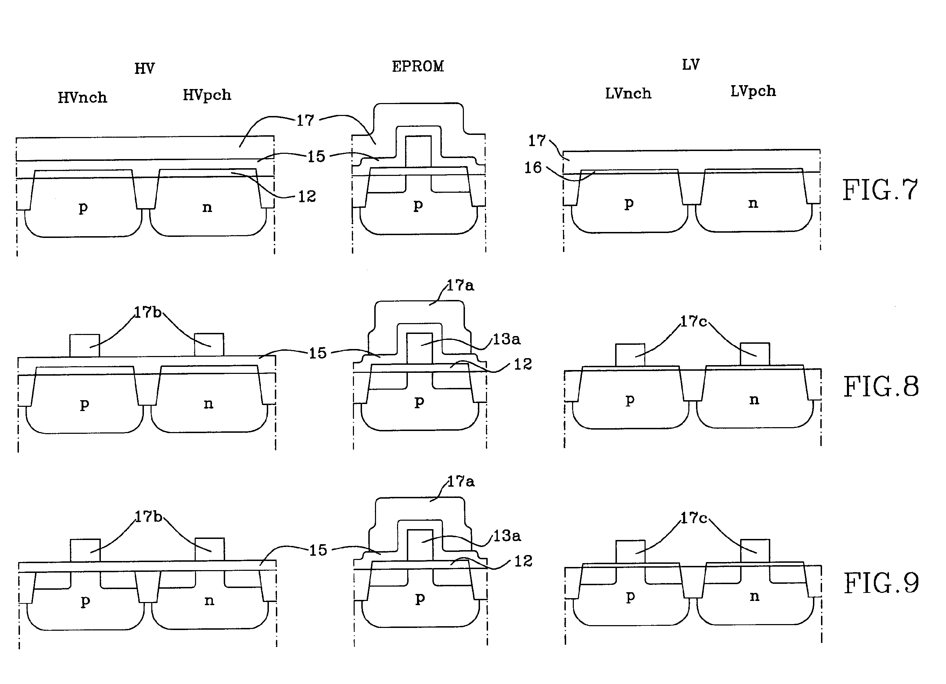

The areas of the substrate affected by this stage of thermal oxidation are those to be used for the LV transistors. In order to subject these to thermal oxidation, they are firstly freed (Fig. 5), by suitable etching processes, from all the layers formed on them by the preceding operations. The parameters in this stage of processing are selected in such a way as to form (Fig. 6) a layer 16 of silicon dioxide having the thickness required for the gate dielectric of the LV transistors (for example, 5 nm).

A second layer of non-doped polycrystalline silicon, indicated by 17 (Fig. 7), is deposited over the whole wafer. The polycrystalline silicon of this layer is then removed selectively, by known photolithographic techniques, to form (Fig. 8) the control gate electrodes 17a of the EPROM cells, the gate electrodes 17b of the HV transistors and the gate electrodes 17c of the LV transistors. Finally, the source and drain regions of the transistors are formed (Fig. 9) in the body regions of the HV and LV transistors in the usual way, by suitable masking and implantation of doping impurities of the n type for the n-channel transistors and of the p type for the p-channel transistors.

The process continues with the usual operations for forming metallic connections between the components of the integrated circuit, for coating with a layer of protective dielectric, for forming terminal contact electrodes of the integrated circuit, for cutting the wafer into chips, and for mounting the individual chips in suitable containing and interconnection structures for connection to an external circuit.

By means of the process according to the invention, it is possible to produce EPROM memory cells suitable for being programmed in a secure way and with a guarantee of excellent stability well more than once, owing to the good characteristics of the composite material (ONO) used for the intermediate dielectric, at the same time as high-quality HV transistors, by using only three masks in addition to those necessary for an ordinary process of fabricating integrated logic circuits containing only LV transistors. The total number of masks is therefore much smaller than it is for a process consisting of a combination of the known specific processes for forming LV transistors, EPROM cells and HV transistors. The process according to the invention is therefore very convenient in terms of production costs, both because the total treatment time is short and because the production yield is relatively high. It should also be noted that the supplementary operations do not interfere with the ordinary operations for forming the constituent elements characteristic of LV transistors (thermal oxide for the gate dielectric, implantation of body, source and drain), and therefore the logic circuits obtainable by the process according to the invention do not differ from those obtainable by an ordinary process designed to produce only this type of circuit.

## Claims

1. Process for forming, on a silicon substrate, an integrated circuit comprising MOS transistors of the LV type with corresponding gate electrodes separated from the substrate by a portion of a first layer of dielectric material (16), MOS transistors of the HV type with corresponding gate electrodes separated from the substrate by a portion of a second layer of dielectric material (12 + 15) and cells of the EPROM type with corresponding floating gate electrodes (13a) separated from the substrate by a portion (12a) of a third layer of dielectric material (12) and with corresponding control electrodes (17a) separated from the corresponding floating gate electrodes (13a) by a portion of a fourth layer of dielectric material (15), this process comprising the following operations:
a) definition on the substrate of areas to be used for the MOS transistors of the LV type, for the MOS transistors of the HV type, and for the cells of the EPROM type,
b) formation of body regions for the MOS transistors of the LV type, for the MOS transistors of the HV type and for the cells of the EPROM type in the corresponding areas,
c) formation of the third layer of dielectric material (12) over all the exposed areas of the substrate,
d) formation of a first layer of polycrystalline silicon (13) on the third layer of dielectric material (12),
e) selective removal of the polycrystalline silicon from the areas to be used for the EPROM type cells for forming the floating gate electrodes (13a) of the cells, and total removal of the polycrystalline silicon (13) from the areas to be used for the HV type MOS transistors,
f) formation of source and drain regions (14) in the body regions of the cells of the EPROM type,
g) formation on all the areas of the fourth layer of dielectric material (15) which, on the areas to be used for the HV type transistors, is superimposed on the third layer of dielectric material (12) to form the second layer of dielectric material (12 + 15),
h) removal of the dielectric material of the fourth layer (15), of the polycrystalline silicon (13) and of the dielectric material of the third layer (12) from the areas to be used for the LV type MOS transistors until the silicon of the substrate is exposed,
i) formation of the first layer of dielectric material (16) on the silicon exposed by the preceding operation,
j) formation of a second layer of polycrystalline silicon (17) on all the areas,
k) selective removal of the polycrystalline silicon of the second layer of polycrystalline silicon (17) to form gate electrodes (17c, 17b) of the LV type and HV type MOS transistors and the control gate electrodes (17a) of the EPROM type cells, and
l) formation of source and drain regions in the body regions of the LV type and HV type MOS transistors.

2. Process according to Claim 1, in which operation g) comprises the successive deposition of a first layer of silicon dioxide, a layer of silicon nitride and a second layer of silicon dioxide.

3. Process according to Claim 1 or 2, in which operation c) comprises an oxidation treatment of the silicon.

4. Process according to any one of the preceding claims, in which operation j) comprises an oxidation treatment of the silicon.
